# EUROPEAN PATENT APPLICATION

(11) **EP 1 553 620 A1**
(43) Date of publication of application: **13.07.2005**
(21) Application number: 04746147.0
(22) Date of filing: 14.06.2004
(51) Int. Cl.: H01L 21/312, H01L 21/318

(54) **SEMICONDUCTOR DEVICE PRODUCING METHOD**

(30) Priority: 20.06.2003 JP 2003175882
(71) Applicant: MATSUSHITA ELECTRIC INDUSTRIAL CO., LTD., Kadoma-shi, Osaka 571-8501 (JP)
(72) Inventor: NAKAGAWA, Hideo, Shiga 523-0064 (JP); SASAGO, Masaru, Osaka 573-0007 (JP); HIRAI, Yoshihiko, Osaka-shi, Osaka 536-0014 (JP)
(74) Representative: Grünecker, Kinkeldey, Stockmair & Schwanhäusser
(86) International application number: PCT/JP2004/008654
(87) International publication number: WO 2004/114388

(57) **Abstract**

A method for forming a semiconductor device includes the steps of forming, on a substrate, a flowable film made of an insulating material with flowability; planarizing a top face of the flowable film by pressing the flowable film with a flat pressing face of a pressing member; forming a solidified film with a flat top face by solidifying the flowable film whose top face has been planarized through annealing of the flowable film performed at a first temperature with the pressing face pressed against the flowable film; and forming a burnt film with a flat top face by burning the solidified film through annealing of the solidified film with a flat top face performed at a second temperature higher than the first temperature.

## Description

### Technical Field

The present invention relates to a method for forming a semiconductor device including an insulating film with a flat top face.

### Background Art

Recently, semiconductor integrated circuit devices are processed according to a fine design rule in the vicinity of 100 nm or less.

In order to form a more refined resist pattern by lithography using light, it is necessary to reduce the wavelength of exposing light.

However, when the wavelength of exposing light is reduced, a focal depth is largely reduced, and therefore, it is indispensable to always keep flat the top face of an insulating film formed on a substrate. Therefore, in the formation of a semiconductor device having a fine design rule of 100 nm or less, a planarization technique for an insulating film on a substrate is very significant.

Currently, the mainly employed planarization technique for an insulating film in a semiconductor device with a design rule of 0.13 µm through 0.25 µm is known chemical mechanical polishing (CMP).

As a method for forming a flat insulating film, a method including the steps of forming a flowable film by supplying a material with flowability onto a substrate, pressing the flowable film with a flat pressing face of a pressing member for planarizing the surface of the flowable film and solidifying the flowable film whose surface has been planarized is known as disclosed in, for example, Patent document 1.

Now, the method for forming a flat insulating film disclosed in Patent document 1 (Japanese Laid-Open Patent Publication No. 2000-350934) will be described with reference to FIGS. **21A** through **21C** and **22A** through **22C.**

First, as shown in FIG. **21A,** a material with flowability, such as a material in the form of a liquid or a gel, is supplied onto a step substrate composed of a substrate **101** of a semiconductor wafer and a layer having irregularities (hereinafter simply referred to as the step layer) **102** formed on the substrate **101,** so as to form a film with flowability (hereinafter simply referred to as the flowable film) **103A** on the step substrate.

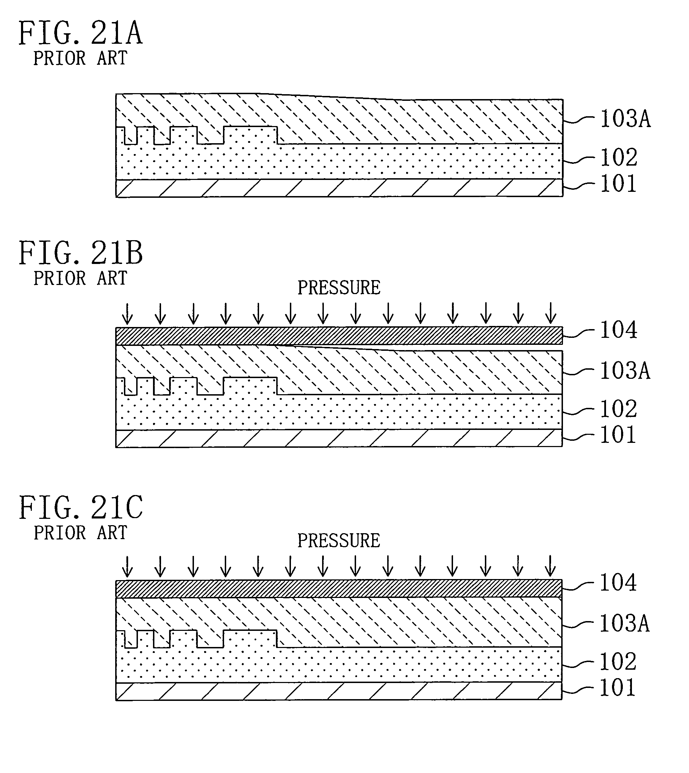

Next, as shown in FIG. **21B,** a flat pressing face of a pressing member **104** is opposed to the surface of the flowable film **103A,** and thereafter, as shown in FIG. **21C,** the flowable film **103A** is pressed toward the step substrate by applying a pressure toward the substrate to the pressing member **104,** so as to planarize the surface of the flowable film **103A.**

In this case, the surface of the flowable film **103A** is planarized over the whole surface of the substrate **101** simply by pressing the flowable film **103A** with the pressing face of the pressing member **104.**

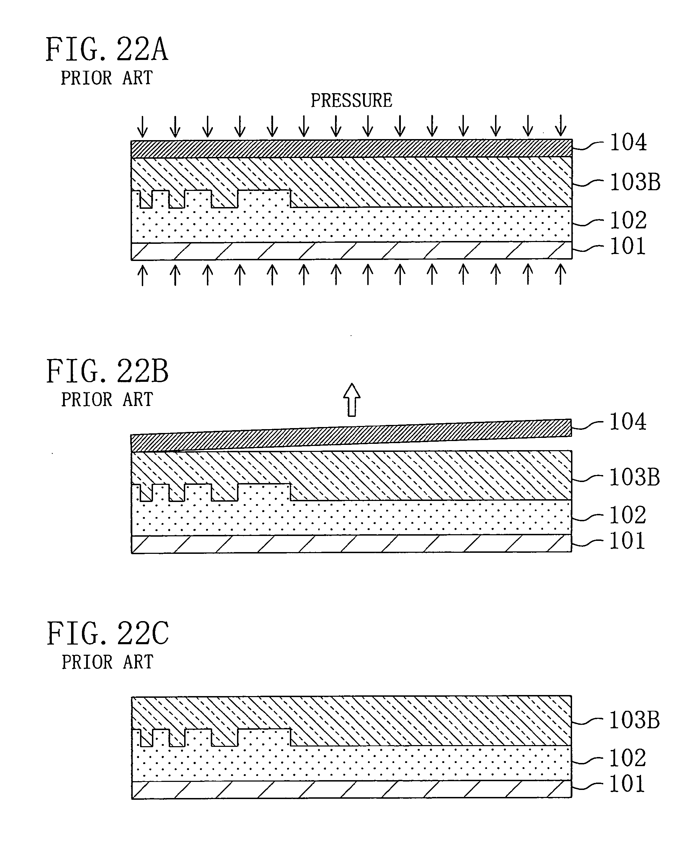

Next, as shown in FIG. **22A,** with the flowable film **103A** pressed toward the substrate **101** with the pressing member **104,** the flowable film **103A** is annealed for causing a chemical reaction within the flowable film **103A,** so as to solidify the flowable film **103A.** Thus, a film having been solidified (hereinafter simply referred to as the solidified film) **103B** having a flat top face is formed.

Then, after completing the annealing, the temperature of the solidified film **103B** is lowered to room temperature, and thereafter, as shown in FIG. **22B,** the pressing member **104** is moved away from the solidified film **103B.** Thus, as shown in FIG. **22C,** the solidified film **103B** having a flat top face can be formed on the step substrate.

In the conventional method for forming a semiconductor device, however, in the case where multilayered interconnects are formed by a damascene method, there arises a problem that the cost of the formation process for the semiconductor device is high because the number of processes is large.

Also, in the case where multilayered interconnects are formed by repeating the damascene method in which a buried interconnect is formed by depositing a metal film on an insulating film for filling a concave portion formed in the insulating film and removing an unnecessary portion of the metal film by the CMP, global level differences are accumulated in the CMP. Therefore, there arises a problem that the heights of the multilayered interconnects from a substrate are largely varied.

Furthermore, in the case where the flat insulating film obtained by the method disclosed in Patent document 1 is used as an interlayer insulating film of a semiconductor device, in order to guarantee the stability of the film quality of the insulating film, an annealing curing process generally performed at a temperature of approximately 400°C is necessary in the solidifying process.

However, in some insulating materials, the structure of the basic skeleton of the insulating film becomes locally ununiform when they are annealed at a temperature of 350°C or more in the solidifying process, which leads to degradation of the film quality that the dielectric coefficient of the insulating film is varied in accordance with the position within the insulation film. As a result, the insulating film cannot attain sufficient reliability, and hence, the performance and the reliability of the semiconductor device are largely degraded.

### Disclosure of the Invention

In consideration of the above-described circumstances, an object of the invention is forming, through a small number of processes, an insulating film that has a high film quality with a uniform structure of a basic skeleton and has a minimum global level difference.

In order to achieve the object, the first method for forming a semiconductor device of this invention includes the steps of forming, on a substrate, a flowable film made of an insulating material with flowability; planarizing a top face of the flowable film by pressing the flowable film with a flat pressing face of a pressing member; forming a solidified film with a flat top face by solidifying the flowable film whose top face has been planarized through annealing of the flowable film performed at a first temperature with the pressing face pressed against the flowable film; and forming a burnt film with a flat top face by burning the solidified film through annealing of the solidified film with a flat top face performed at a second temperature higher than the first temperature.

In the first method for forming a semiconductor device, after pressing the flowable film with the flat pressing face of the pressing member, the solidifying process and the burning process are performed. Therefore, an insulating film made of the burnt film with a minimum global level difference and a flat top face can be formed through a small number of processes. Also, the annealing is performed on the flowable film at the first temperature that is a relatively low temperature, and thus, the basic skeleton of the solidified film (such as a polymer skeleton of an organic film, a siloxane skeleton of a silicon oxide film or an organic-inorganic film, or a resin skeleton of a resist film) is formed. Thereafter, the annealing is performed on the solidified film at the second temperature that is a relatively high temperature, so as to vaporize porogen such as an acrylic polymer, a remaining solvent or the like from the solidified film. Therefore, as compared with the case where formation of a basic skeleton and vaporization of the porogen, a remaining solvent or the like are performed in parallel, the structure of the basic skeleton of the insulating film made of the burnt film is uniform, resulting in improving the film quality of the insulating film. Accordingly, the dielectric constant of the insulating film is uniform within the whole film, and the insulating film attains high reliability.

The second method for forming a semiconductor device of this invention includes the steps of forming, on a substrate, a flowable film made of an insulating material with flowability over the substrate including a buried interconnect formed and exposed on the substrate; planarizing a top face of the flowable film by pressing the flowable film with a flat pressing face of a pressing member; forming a solidified film with a flat top face by solidifying the flowable film whose top face has been planarized through annealing of the flowable film performed at a first temperature with the pressing face pressed against the flowable film; forming a burnt film with a flat top face by burning the solidified film through annealing of the solidified film with a flat top face performed at a second temperature higher than the first temperature; and forming a buried plug connected at least to the interconnect by forming a via hole in the burnt film and filling the via hole with a metal material.

In the second method for forming a semiconductor device, after pressing the flowable film with the flat pressing face of the pressing member, the solidifying process and the burning process are performed. Therefore, an insulating film made of the burnt film with a minimum global level difference and a flat top face can be formed through a small number of processes. Also, the annealing is performed on the flowable film at the first temperature that is a relatively low temperature, and thus, the basic skeleton of the solidified film is formed. Thereafter, the annealing is performed on the solidified film at the second temperature that is a relatively high temperature, so as to vaporize porogen such as an acrylic polymer, a remaining solvent or the like from the solidified film. Therefore, the structure of the basic skeleton of the insulating film made of the burnt film is uniform, resulting in improving the film quality of the insulating film. Accordingly, the dielectric constant of the insulating film is uniform within the whole film, and the insulating film attains high reliability.

The third method for forming a semiconductor device of this invention includes the steps of forming, on a substrate, a flowable film made of an insulating material with flowability over the substrate including a buried plug formed and exposed on the substrate; planarizing a top face of the flowable film by pressing the flowable film with a flat pressing face of a pressing member; forming a solidified film with a flat top face by solidifying the flowable film whose top face has been planarized through annealing of the flowable film performed at a first temperature with the pressing face pressed against the flowable film; forming a burnt film with a flat top face by burning the solidified film through annealing of the solidified film with a flat top face performed at a second temperature higher than the first temperature; and forming a buried interconnect connected at least to the plug by forming an interconnect groove in the burnt film and filling the interconnect groove with a metal material.

In the third method for forming a semiconductor device, after pressing the flowable film with the flat pressing face of the pressing member, the solidifying process and the burning process are performed. Therefore, an insulating film made of the burnt film with a minimum global level difference and a flat top face can be formed through a small number of processes. Also, the annealing is performed on the flowable film at the first temperature that is a relatively low temperature, and thus, the basic skeleton of the solidified film is formed. Thereafter, the annealing is performed on the solidified film at the second temperature that is a relatively high temperature, so as to vaporize porogen such as an acrylic polymer, a remaining solvent or the like from the solidified film. Therefore, the structure of the basic skeleton of the insulating film made of the burnt film is uniform, resulting in improving the film quality of the insulating film. Accordingly, the dielectric constant of the insulating film is uniform within the whole film, and the insulating film attains high reliability.

In any of the first through third methods for forming a semiconductor device, the first temperature is preferably approximately 150°C through approximately 300°C.

Thus, the basic skeleton of the flowable film can be formed without vaporizing the porogen or the like included in the flowable film.

In any of the first through third methods for forming a semiconductor device, the second temperature is preferably approximately 350°C through approximately 450°C.

Thus, the porogen or the like can be vaporized from the solidified film without degrading the film quality of the solidified film and also the film quality of the burnt film.

In any of the first through third methods for forming a semiconductor device, the insulating material with flowability is preferably in the form of a liquid or a gel.

Thus, the flowable film can be easily and definitely formed.

In any of the first through third methods for forming a semiconductor device, in the step of forming a flowable film, the flowable film is preferably formed on the substrate by supplying the insulating material with flowability onto the substrate rotated.

Thus, the thickness of the flowable film can be made uniform.

In any of the first through third methods for forming a semiconductor device, in the step of forming a flowable film, the flowable film is preferably formed on the substrate by supplying the insulating material with flowability onto the substrate and rotating the substrate after the supply.

Thus, the thickness of the flowable film can be made uniform.

In any of the first through third methods for forming a semiconductor device, in the step of forming a flowable film, the flowable film is preferably formed on the substrate by supplying, in the form of a shower or a spray, the insulating material with flowability onto the substrate rotated.

Thus, the flowable film can be definitely formed in a comparatively small thickness.

In any of the first through third methods for forming a semiconductor device, in the step of forming a flowable film, the flowable film is preferably formed on the substrate by supplying the insulating material with flowability from a fine spray vent of a nozzle onto the substrate with the nozzle having the fine spray vent and the substrate relatively moved along plane directions.

Thus, the thickness of the flowable film can be controlled to be a desired thickness by adjusting the relative moving rates of the nozzle and the substrate. Also, the degree of the flowability of the flowable film can be changed by adjusting the viscosity of the material with flowability. Furthermore, the process speed can be controlled by adjusting the number of nozzles.

In any of the first through third methods for forming a semiconductor device, in the step of forming a flowable film, the flowable film is preferably formed on the substrate by supplying the insulating material with flowability having been adhered to a surface of a roller onto the substrate with the roller rotated.

Thus, the thickness of the flowable film can be controlled by adjusting a distance between the roller and the substrate and a force for pressing the roller against the substrate. Also, a material with flowability and high viscosity can be used.

Each of the first through third methods for forming a semiconductor device preferably further includes, between the step of forming a flowable film and the step of planarizing a top face of the flowable film, a step of selectively removing a peripheral portion of the flowable film.

Thus, the peripheral portion of the substrate can be mechanically held in the process for forming the burnt film with ease.

In the case where any of the first through third methods for forming a semiconductor device includes the step of selectively removing a peripheral portion of the flowable film, this step is preferably performed by supplying a solution for dissolving the insulating material with flowability onto the peripheral portion of the flowable film with the flowable film rotated.

Thus, the flowable film can be definitely removed from a peripheral portion of a substrate in the plane shape of a circle or a polygon with a large number of vertexes.

In the case where any of the first through third methods for forming a semiconductor device includes the step of selectively removing a peripheral portion of the flowable film, this step is preferably performed by modifying the peripheral portion of the flowable film through irradiation with light and removing the modified peripheral portion.

Thus, the flowable film can be definitely removed from a peripheral portion of a substrate not only in the plane shape of a circle or a polygon with a large number of vertexes but also in the shape of a polygon with a small number of vertexes such as a triangle or a rectangle.

In any of the first through third methods for forming a semiconductor device, in the step of planarizing a top face of the flowable film, it is preferred that a plurality of distances between a surface of the substrate and the pressing face are measured, and that the flowable film is pressed with the pressing face in such a manner that the plurality of distances are equal to one another.

Thus, a distance of the surface of the flowable film from the surface of the substrate can be always made uniform, and therefore, an operation for making uniform a distance between the surface of the substrate and the pressing face of the pressing member every given period of time can be omitted.

In each of the first through third methods for forming a semiconductor device, in the step of planarizing a top face of the flowable film, it is preferred that a plurality of distances between a surface of a stage where the substrate is placed and the pressing face are measured, and that the flowable film is pressed with the pressing face in such a manner that the plurality of distances are equal to one another.

Thus, a distance of the surface of the flowable film from the surface of the substrate can be always made uniform, and therefore, an operation for making uniform a distance between the surface of the substrate and the pressing face of the pressing member every given period of time can be omitted.

In any of the first through third methods for forming a semiconductor device, in the case where the plurality of distances between the surface of the substrate or the stage and the pressing face are measured, the plurality of distances are preferably measured by measuring capacitance per unit area in respective measurement positions.

Thus, the plural distances can be easily and definitely measured.

In any of the first through third methods for forming a semiconductor device, the pressing face of the pressing member preferably has a hydrophobic property.

Thus, the pressing member can be easily moved away from the solidified film, and therefore, a solidified film with fewer defects and also a burnt film with fewer defects can be formed.

In any of the first through third methods for forming a semiconductor device, it is preferred that the insulating material with flowability is a photo-setting resin, and that the step of forming a solidified film includes a sub-step of irradiating the flowable film with light.

Thus, the flowable film can be easily and rapidly solidified through a photochemical reaction and a thermal chemical reaction.

In any of the first through third methods for forming a semiconductor device, the insulating material with flowability is preferably an organic material, an inorganic material, an organic-inorganic material, a photo-setting resin or a photosensitive resin.

In any of the first through third methods for forming a semiconductor device, in the step of forming a burnt film, the solidified film is preferably annealed at the second temperature with the pressing face pressed against the solidified film.

Thus, the flatness of the solidified film with a flat top face can be accurately kept.

In any of the first through third methods for forming a semiconductor device, in the step of forming a burnt film, the solidified film is preferably annealed at the second temperature with the pressing face moved away from the solidified film.

Thus, the porogen, the remaining solvent or the like included in the solidified film can be easily vaporized.

In any of the first through third methods for forming a semiconductor device, the burnt film is preferably a porous film.

Thus, an insulating film made of the burnt film with a low dielectric constant can be formed.

In any of the first through third methods for forming a semiconductor device, the burnt film preferably has a dielectric constant of approximately 4 or less.

Thus, the dielectric constant of the insulating film can be definitely lowered, so as to reduce capacitance between metal interconnects.

The second method for forming a semiconductor device preferably further includes, before the step of forming a flowable film, a step of forming the buried interconnect exposed on the substrate by forming a buried interconnect in an organic film formed on the substrate and removing the organic film.

The third method for forming a semiconductor device preferably further includes, before the step of forming a flowable film, a step of forming the buried plug exposed on the substrate by forming a buried plug in an organic film formed on the substrate and removing the organic film.

In the second or third method for forming a semiconductor device, the organic film is preferably removed by wet etching in the step of forming the buried interconnect or the buried plug.

In the second or third method for forming a semiconductor device, the organic film is preferably removed by dry etching in the step of forming the buried interconnect or the buried plug.

### Brief Description of Drawings

FIGS. **1A** through **1D** are cross-sectional views for showing procedures in a method for forming a semiconductor device according to Embodiment 1.
FIGS. **2A** through **2C** are cross-sectional views for showing other procedures in the method for forming a semiconductor device according to Embodiment 1.
FIG. **3A** is a flowchart for showing a sequence of a conventional method for forming a semiconductor device and FIG. **3B** is a flowchart for showing a sequence of the method for forming a semiconductor device according to Embodiment 1 or 2.
FIGS. **4A** through **4C** are cross-sectional views for showing procedures in Example 1 employed in the method for forming a semiconductor device according to Embodiment 1 or 2.
FIGS. **5A** and **5B** are cross-sectional views for showing procedures in Example 2 employed in the method for forming a semiconductor device according to Embodiment 1 or 2.
FIGS. **6A** and **6B** are cross-sectional views for showing procedures in Example 3 employed in the method for forming a semiconductor device according to Embodiment 1 or 2.
FIGS. **7A** and **7B** are cross-sectional views for showing procedures in Example 4 employed in the method for forming a semiconductor device according to Embodiment 1 or 2.
FIGS. **8A** through **8C** are cross-sectional views for showing procedures in a method for forming a semiconductor device according to Embodiment 3.
FIGS. **9A** through **9C** are cross-sectional views for showing other procedures in the method for forming a semiconductor device according to Embodiment 3.
FIGS. **10A** and **10B** are cross-sectional views for showing procedures in a method for forming a semiconductor device according to Embodiment 4.
FIGS. **11A** and **11B** are cross-sectional views for showing other procedures in the method for forming a semiconductor device according to Embodiment 4.
FIGS. **12A** and **12B** are cross-sectional views for showing procedures in a method for forming a semiconductor device according to Embodiment 5.
FIGS. **13A** through **13F** are cross-sectional views for showing procedures in a method for forming a semiconductor device according to Embodiment 6.
FIGS. **14A** through **14D** are cross-sectional views for showing other procedures in the method for forming a semiconductor device according to Embodiment 6.
FIGS. **15A** through **15D** are cross-sectional views for showing other procedures in the method for forming a semiconductor device according to Embodiment 6.
FIGS. **16A** through **16D** are cross-sectional views for showing other procedures in the method for forming a semiconductor device according to Embodiment 6.
FIGS. **17A** through **17F** are cross-sectional views for showing procedures in a method for forming a semiconductor device according to Embodiment 7.
FIGS. **18A** through **18D** are cross-sectional views for showing other procedures in the method for forming a semiconductor device according to Embodiment 7.
FIGS. **19A** through **19D** are cross-sectional views for showing other procedures in the method for forming a semiconductor device according to Embodiment 7.
FIGS. **20A** through **20D** are cross-sectional views for showing other procedures in the method for forming a semiconductor device according to Embodiment 7.
FIGS. **21A** through **21C** are cross-sectional views for showing procedures in a conventional method for forming a semiconductor device.
FIGS. **22A** through **22C** are cross-sectional views for showing other procedures in the conventional method for forming a semiconductor device.

### Best Mode for Carrying Out the Invention

### (EMBODIMENT 1)

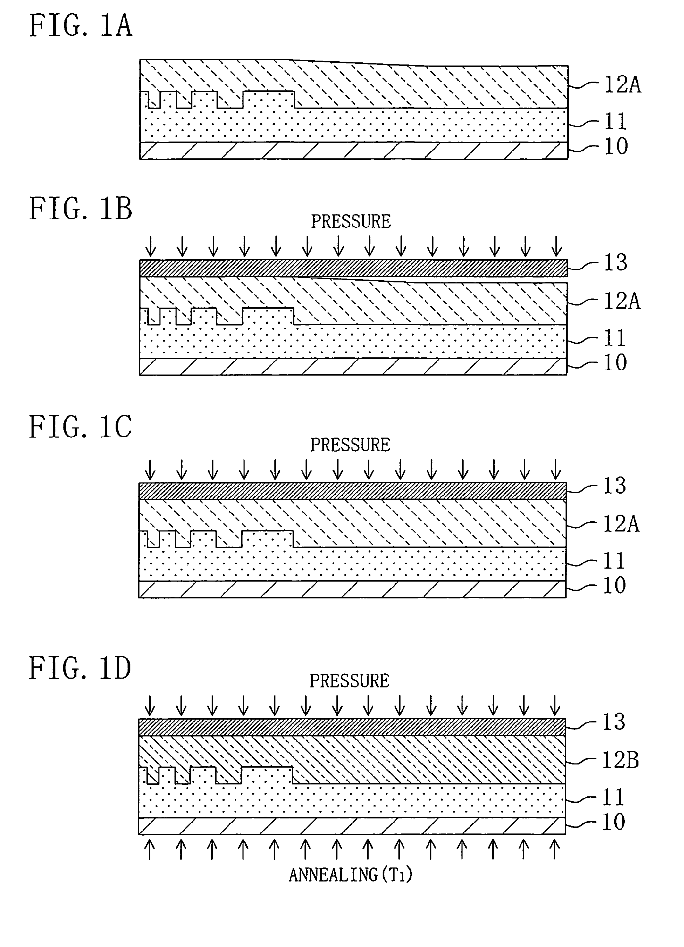

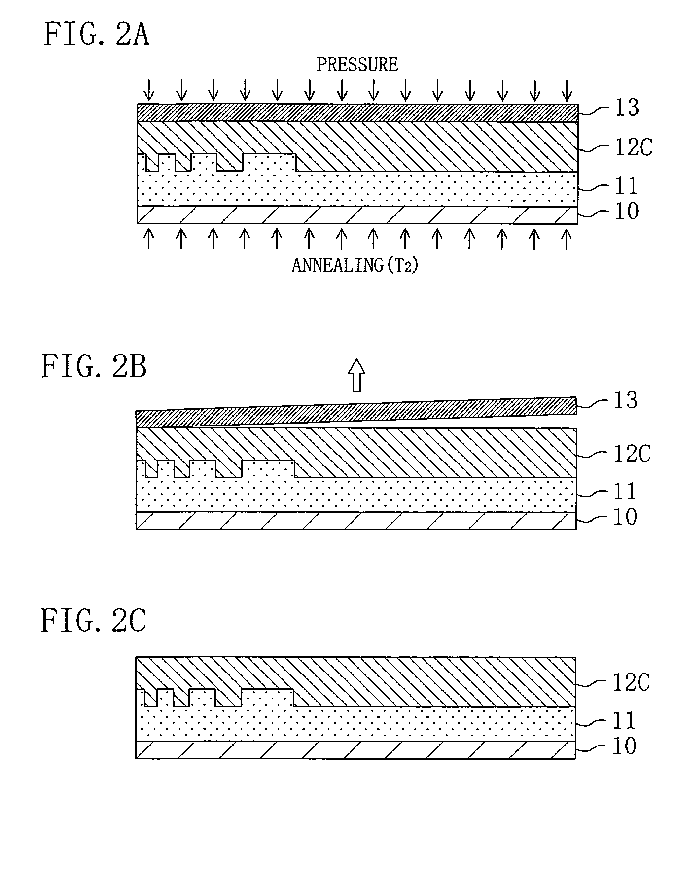

A method for forming a semiconductor device according to Embodiment 1 will now be described with reference to FIGS. **1A** through **1D** and **2A** through **2C.**

First, as shown in FIG. **1A,** after forming a step layer **11** on a substrate **10** of a semiconductor wafer, a material with flowability, such as a material in the form of a liquid or a gel, is supplied onto the step layer **11,** so as to form a flowable film **12A.** The plane shape of the substrate **10** is not particularly specified and may be any shape including a circle, a polygon and the like.

In general, annealing is performed at approximately 80°C through 120°C in order to vaporize a part or most of a solvent included in the flowable film **12A** formed above the substrate **10.** This annealing is generally designated as pre-bake, and the temperature of the pre-bake may be set so that the flowability of the flowable film **12A** can be kept in a planarizing process subsequently performed. Specifically, the temperature may be set in accordance with the characteristics (such as the boiling point) of the solvent used for supplying the material with flowability, and the pre-bake may be omitted in some cases.

The flowable film **12A** may be, for example, an organic film, an inorganic film, an organic-inorganic film (organic-inorganic hybrid film), a photo-setting resin film that is cured through irradiation with light, a photosensitive resin film such as a resist film, a porous film having a large number of pores with a diameter of approximately 1 nm through 10 nm therein, or the like.

A method for forming the flowable film **12A** may be a spin coating method, a microscopic spraying method, a rotation roller method or the like, the thickness of the flowable film **12A** is adjusted differently depending upon the employed method, and the film thickness can be adjusted by selecting the method for forming the flowable film **12A.** The method for forming the flowable film **12A** will be described in detail in Examples 1 through 4 below.

In the case where the flowable film **12A** is used as an interlayer film of multilayered interconnects, the material with flowability is preferably an insulating material.

Next, as shown in FIG. **1B,** a flat pressing face of a pressing member **13** is opposed to the surface of the flowable film **12A,** and thereafter, as shown in FIG. **1C**, a pressure toward the substrate is applied to the pressing member **13,** so as to planarize the whole top face of the flowable film **12A.**

In this case, merely by pressing the flowable film 12A with the pressing face of the pressing member **13,** the whole top face of the flowable film **12A** is planarized. However, when the press with the pressing member **13** is intermitted, the flowable film **12A** is changed into an energetically stable shape owing to the surface tension of the flowable film 12A.

Therefore, as shown in FIG. **1D**, with the pressing member **13** pressed against the flowable film **12A,** the flowable film **12A** is annealed at a first temperature **(T1)** so as to cause a chemical reaction within the flowable film **12A.** Thus, the flowable film **12A** is solidified, thereby forming a solidified film **12B** made of the flowable film **12A** solidified and having a flat top face. The first temperature **(T1)** is preferably approximately 150°C through approximately 300°C and is more preferably approximately 200°C through approximately 250°C. In this manner, the basic skeleton of the flowable film **12A,** such as a polymer skeleton or a siloxane skeleton, is definitely formed. In the solidifying process, the annealing is performed with a hot plate set to a desired temperature for approximately 2 through 3 minutes.

Next, as shown in FIG. **2A,** with the pressing member **13** pressed against the solidified film **12B,** the solidified film **12B** is annealed at a second temperature (**T2**) higher than the first temperature **(T1)** for burning the solidified film **12B.** Thus, a burnt film **12C** made of the solidified film 12B burnt and having a flat top face is formed. The second temperature (**T2**) is preferably approximately 350°C through approximately 450°C. In this manner, porogen or the like is vaporized from the solidified film **12B** where the basic skeleton has been formed, and hence, the burnt film **12C** with a uniform film quality can be obtained. In the process for forming the burnt film **12C,** the annealing is performed with a hot plate set to a desired temperature for approximately 2 through approximately 15 minutes.

Next, after lowering the temperature of the burnt film **12C** to a temperature range between approximately 100°C and room temperature, as shown in FIG. **2B,** the pressing member **13** is moved away from the burnt film **12C,** and thereafter, the temperature of the burnt film **12C** is ultimately lowered to room temperature. Thus, as shown in FIG. **2C,** the burnt film **12C** that is flat in the whole top face is obtained.

In order to provide the pressing face of the pressing member **13** with a hydrophobic property, the pressing face is preferably subjected to a Teflon (registered trademark) coating treatment or a surface treatment with a silicon coupling material. Thus, the pressing member **13** can be easily moved away from the burnt film **12C,** and hence, the burnt film **12C** with fewer defects can be formed.

Now, materials with flowability will be described.

The material with flowability used for forming an organic film is, for example, an aromatic polymer having aryl ether as a principal skeleton, and specific examples are FLARE and GX-3 (manufactured by Honeywell) and SiLK (manufactured by Dow Chemical).

The material with flowability used for forming an inorganic film is, for example, HSQ (hydrogen silsquioxane) or organic SOG such as an alkylsiloxane polymer, and a specific example of the HSQ is Fox (manufactured by Dow Coming) and a specific example of the organic SOG is HSG-RZ25 (manufactured by Hitachi Chemical Co., Ltd.).

The material with flowability used for forming an organic-inorganic film is, for example, organic siloxane having an organic group such as a methyl group in a siloxane skeleton, and a specific example is HOSP (hybrid organic siloxane polymer) (manufactured by Honeywell).

The material with flowability used for forming a photo-setting resin film is, for example, PDGI (polydimethyl glutar imide), and a specific example is SAL101 (manufactured by Shipley Far East).

The material with flowability used for forming a photosensitive resin film may be a general resist material used in the lithography.

The material with flowability used for forming a porous film is, for example, an organic, inorganic or organic-inorganic material having pores, a specific example of the organic material having pores is Porous FLARE (manufactured by Honeywell), a specific example of the inorganic material having pores is XLK (manufactured by Dow Corning) having pores in HSQ (hydrogen silsquioxane), and specific examples of the organic-inorganic material having pores are Nanoglass (manufactured by Honeywell) and LKD-5109 (manufactured by JSR).

When the burnt film **12C** obtained by solidifying and burning the flowable film **12A** made of any of the aforementioned materials is used as an interlayer insulating film of multilayered interconnects, an interlayer insulating film that is dense and has a lower dielectric constant than a general silicon oxide film (with a dielectric constant of approximately 4) can be obtained. Therefore, a film suitable to a semiconductor device refined to 100 nm or less can be realized. In particular, when a porous film is used as the burnt film **12C,** an interlayer insulating film with a very low dielectric constant of 2 or less can be realized.

### (EMBODIMENT 2)

A method for forming a semiconductor device according to Embodiment 2 will now be described with reference to FIGS. **1A** through **1D** and **2A** through **2C.**

Since the basic process sequence of Embodiment 2 is almost the same as that of Embodiment 1, a difference from that of Embodiment 1 will be principally described below.

First, in the same manner as in Embodiment 1, after forming a step layer 11 on a substrate **10,** a flowable film **12A** is formed on the step layer **11.** Thereafter, a pressing member **13** is pressed against the flowable film **12A,** so as to planarize the whole top face of the flowable film **12A.**

Next, with the pressing member **13** pressed against the flowable film **12A,** the flowable film **12A** is annealed at a first temperature (**T1**), so as to form a solidified film **12B** having a flat top face.

Then, after moving the pressing member **13** away from the solidified film **12B,** the solidified film **12B** is annealed at a second temperature (**T2**) higher than the first temperature **(T1)** for burning the solidified film **12B,** thereby forming a burnt film **12C** made of the burnt solidified film **12B.** Thereafter, the temperature of the burnt film **12C** is lowered to approximately room temperature. Thus, the burnt film **12C** having a flat top face is formed.

A difference between Embodiment 1 and Embodiment 2 is that the solidified film **12B** is burnt with the pressing face of the pressing member **13** pressed against the solidified film **12B** in Embodiment 1 while it is burnt with the pressing face of the pressing member **13** moved away from the solidified film **12B** in Embodiment 2. Accordingly, in Embodiment 2, it is necessary to perform the annealing with a hot plate in the solidifying process but the annealing can be performed with a hot plate or a furnace in the burning process.

Embodiment 2 is more effective than Embodiment 1 in the case where a solidified film largely outgassing is annealed in the burning process. In a general film, the concentration of a remaining solvent in the film can be controlled through the pre-bake, and therefore, the film minimally outgases in the burning process, but depending upon the composition of the film, it may outgas in the burning process where the annealing is performed at a comparatively high temperature. In such a case, there may arise a problem of uniformity or stability of the burnt film **12C** when the burning process of Embodiment 1 is performed, and hence, the burning process of Embodiment 2 is preferably performed. In particular, this effect is exhibited when the burnt film **12C** is a porous film. In a porous film, most of the basic structure of the film is formed through the annealing performed at the first temperature **(T1)** in the solidifying process, and a pore forming material added for forming pores is vaporized through the annealing performed at the second temperature **(T2)** in the burning process. Therefore, the burning process of Embodiment 2 in which the film is burnt with the pressing member **13** moved away from the solidified film **12B** is suitable. Even in a porous film, if it is an optimal film in which the basic skeleton of the film is formed and most of a pore forming material is vaporized in the solidifying process, a good burnt film **12C** can be obtained even by employing the burning process of Embodiment 1.

In Embodiment 1 or 2, the annealing temperature of the burning process (the second temperature) is set to be higher than the annealing temperature of the solidifying process (the first temperature). In the case where the burnt film **12C** is used as an insulating film of a semiconductor device, the annealing temperature of the solidifying process (the first temperature) is preferably approximately 150°C through 300°C, and the annealing temperature of the burning process (the second temperature) is preferably approximately 350°C through 450°C.

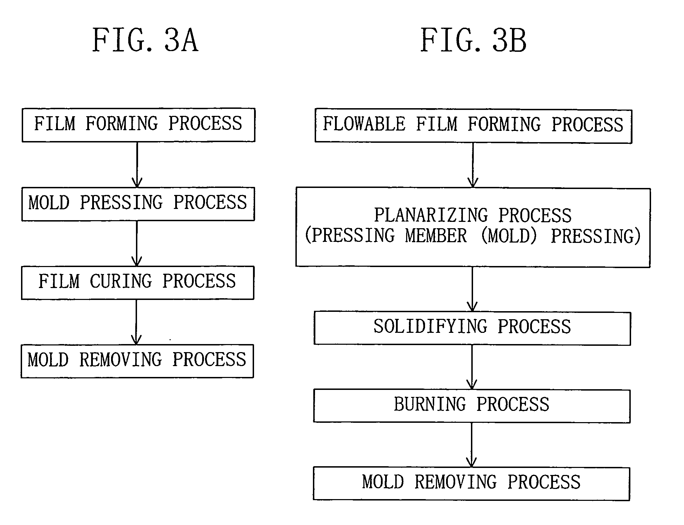

Next, a difference between a conventional method for forming a semiconductor device and the present method for forming a semiconductor device will be described with reference to FIGS. **3A** and **3B.**

As shown in FIG. **3A,** in the conventional method for forming a semiconductor device, a film having a flat top face is formed through one annealing in a film curing process performed after pressing with a pressing member (a mold). On the contrary, as shown in FIG. **3B,** in the present method for forming a semiconductor device, after pressing with the pressing member (a mold) (after the planarizing process), a flat burnt film **12C** is formed through the annealing performed in the two stages in the solidifying process and the burning process.

### <Example 1>

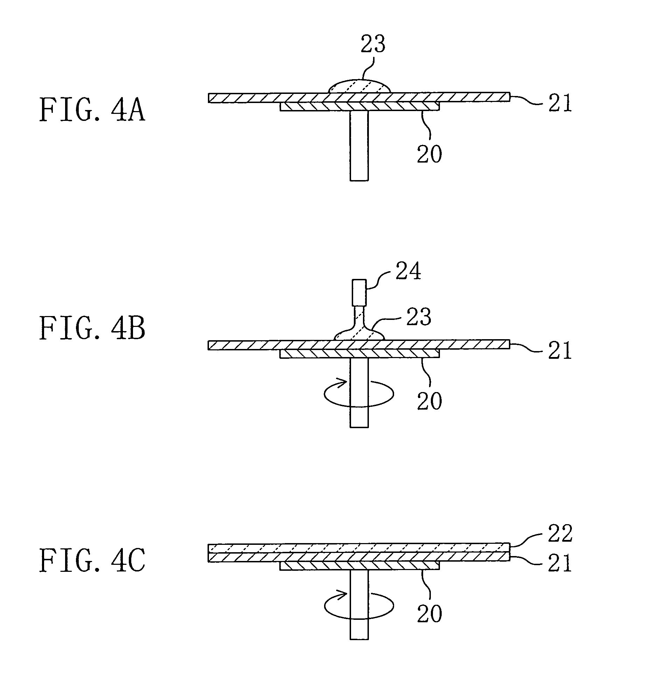

As a method for forming a flowable film used in Embodiment 1 or 2, a first spin coating method will now be described with reference to FIGS. **4A** through **4C**.

First, as shown in FIG. **4A,** after holding a substrate **21** through vacuum adsorption on a rotatable stage **20,** an appropriate amount of material **23** with flowability is dropped on the substrate **21,** and thereafter, the stage **20** is rotated. Alternatively, as shown in FIG. **4B,** after holding a substrate **21** through vacuum adsorption on a rotatable stage **20,** a material **23** with flowability is supplied from a dropping nozzle **24** onto the substrate **21** while rotating the stage **20** together with the substrate **21.**

In this manner, a flowable film **22** is formed on the substrate **21** as shown in FIG. **4C**.

In either of the method shown in FIG. **4A** and the method shown in FIG. **4B,** when the viscosity of the material **23** with flowability and the rotation speed of the stage **20** are optimized, the flowable film **22** can attain hardness suitable for the process for transferring the flat surface of the pressing face of the pressing member **13** (see FIG. **1B** or **2B)** onto the flowable film **22.**

It is noted that the method of Example 1 is suitable to a case where the flowable film 22 is formed in a comparatively large thickness.

### <Example 2>

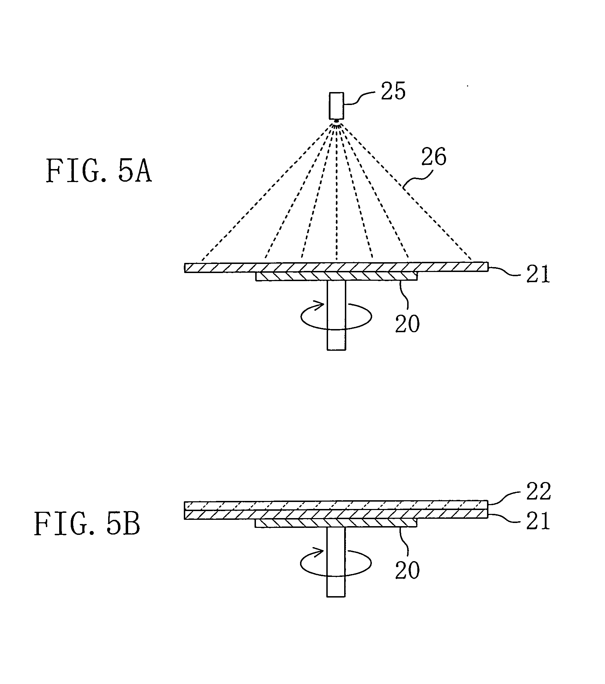

As a method for forming a flowable film used in Embodiment 1 or 2, a second spin coating method will now be described with reference to FIGS. **5A** and **5B.**

First, as shown in FIG. **5A,** after holding a substrate **21** through vacuum adsorption on a rotatable stage **20,** a material **26** with flowability is supplied in the form of a shower or spray from a spray nozzle **25** onto the substrate **21** while rotating the stage **20** together with the substrate **21.**

After supplying a desired amount of material **26** with flowability, the stage **20** is continuously rotated for a predetermined period of time. Thus, a flowable film **22** is formed on the substrate **21** as shown in FIG. **5B.**

The method of Example 2 is suitable to a case where the flowable film **22** is formed in a comparatively small thickness.

### <Example 3>

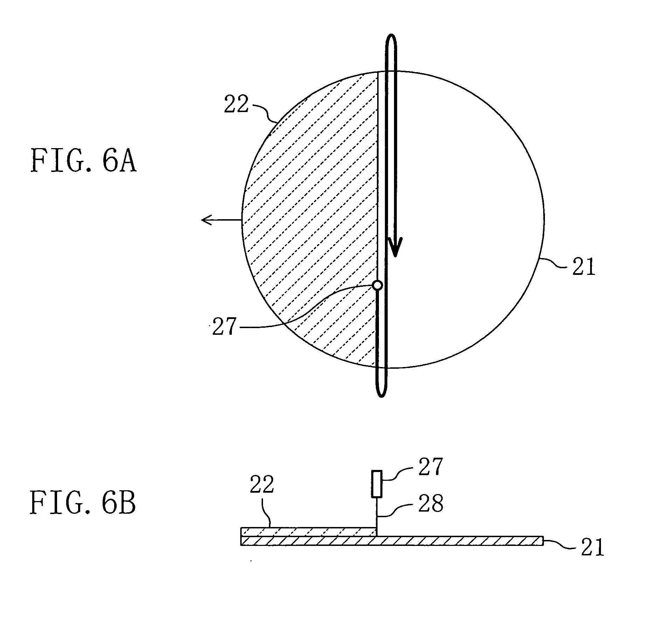

As a method for forming the flowable film used in Embodiment 1 or 2, a microscopic spraying method will now be described with reference to FIGS. **6A** and **6B.**

First, as shown in FIG. **6A,** a material **28** with flowability is supplied from a dropping nozzle **27** onto a substrate **21** by a given amount at a time while moving the substrate **21** along one of the two perpendicular directions of the two-dimensional rectangular coordinate system, for example, along the lateral direction of FIG. **6A** and moving the dropping nozzle **27** along the other of the two perpendicular directions, for example, along the longitudinal direction of FIG. **6A.** In other words, an operation for moving the substrate **21** by a given distance toward the leftward direction in FIG. **6A** and stopping it is repeatedly performed, and while the substrate **21** is stopped, the material **28** with flowability is supplied from the dropping nozzle **27** onto the substrate **21** by a given amount at a time while moving the dropping nozzle **27** along the longitudinal direction in FIG. **6A.**

In this manner, a flowable film **22** is formed on the substrate **21** as shown in FIG. **6B.**

In the method of Example 3, the thickness of the flowable film **22** can be controlled over a range from a small thickness to a large thickness by adjusting the amount of material **28** with flowability supplied from the dropping nozzle **27** and the moving rate of the dropping nozzle **27.**

Also, the degree of the flowability of the flowable film **22** can be changed by adjusting the viscosity of the material **28** with flowability supplied from the dropping nozzle **27.**

Furthermore, the process speed can be controlled by adjusting the number of dropping nozzles **27.**

### <Example 4>

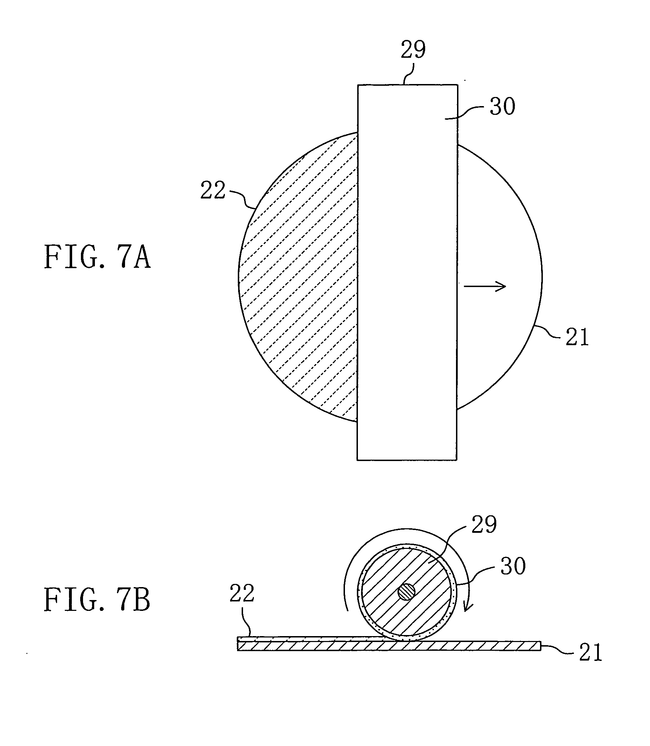

As a method for forming a flowable film used in Embodiment 1 or 2, a rotation roller method will now be described with reference to FIGS. **7A** and **7B.**

As shown in FIGS. **7A** and **7B,** with a material **30** with flowability uniformly adhered onto the peripheral face of a rotation roller **29,** the rotation roller **29** is rotationally moved on the surface of a substrate **21.**

In this manner, the material **30** with flowability is adhered onto the surface of the substrate **21,** and hence, a flowable film **22** is formed on the substrate **21** as shown in FIG. **7B.**

In the method of Example 4, the thickness of the flowable film **22** can be controlled by adjusting the distance between the rotation roller **29** and the substrate **21** and a force for pressing the rotation roller **29** against the substrate **21.**

Also, the method of Example 4 is suitable to a case where the material 30 with flowability is in the form of a highly viscous liquid or a gel.

### (EMBODIMENT 3)

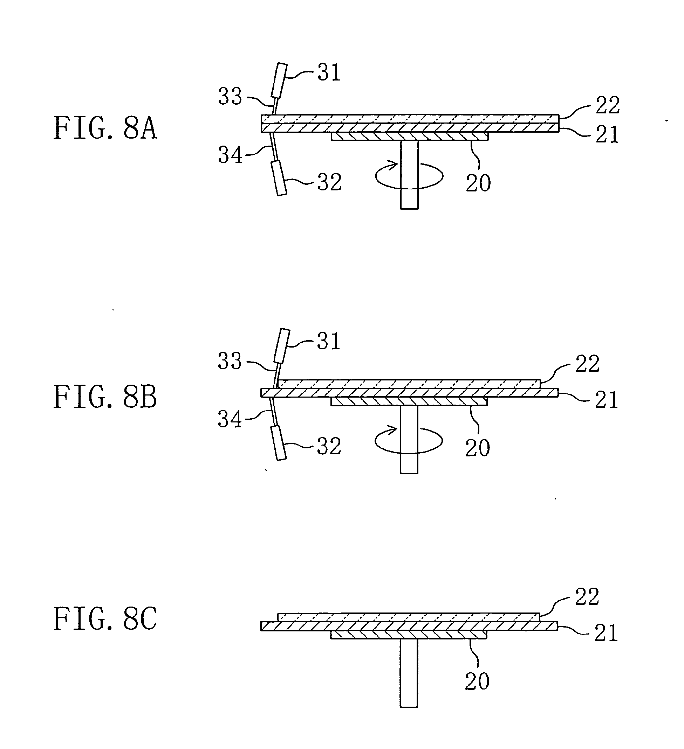

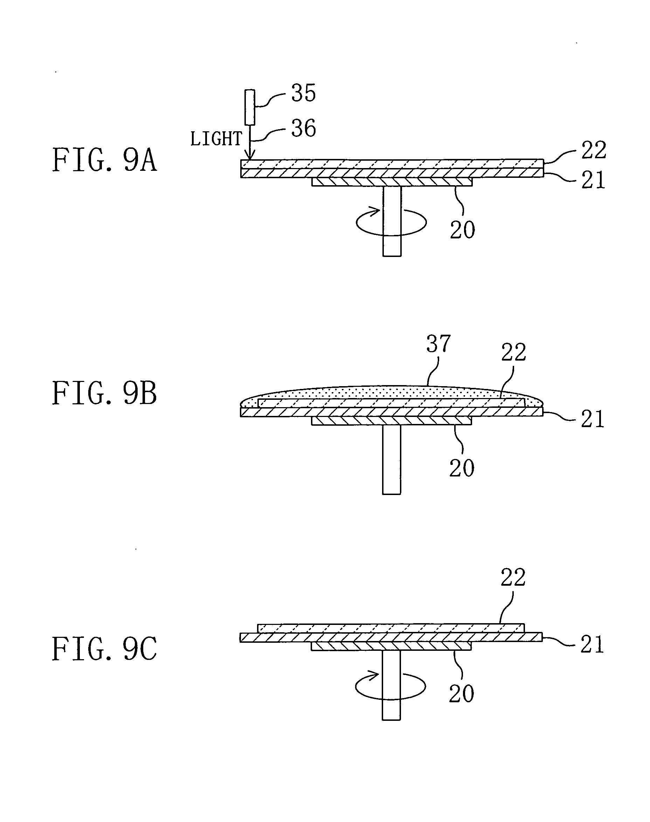

A method for forming a semiconductor device according to Embodiment 3 will now be described with reference to FIGS. **8A** through **8C** and **9A** through **9C.**

In Embodiment 3, methods for selectively removing a peripheral portion of the flowable film obtained in Embodiment 1 or 2 are described. Specifically, in a first method, the peripheral portion is removed by supplying a solution for dissolving the flowable film to the peripheral portion of the flowable film while rotating the substrate on which the flowable film is formed, and in a second method, the peripheral portion of the flowable film is modified by irradiating the peripheral portion with light and thereafter the modified peripheral portion is removed.

In Embodiment 1 or 2, the flowable film is formed over the whole surface of the substrate, namely, also on a peripheral portion of the substrate. However, it is sometimes necessary to mechanically hold the peripheral portion of the substrate.

Embodiment 3 is devised for overcoming such a problem, and since the peripheral portion of the flowable film is selectively removed in Embodiment 3, the peripheral portion of the substrate can be easily mechanically held.

Now, the first method for selectively removing the peripheral portion of a flowable film **22** will be described with reference to FIGS. **8A** through **8C.**

First, as shown in FIG. **8A,** after a substrate **21** on which the flowable film **22** is formed is held through vacuum adsorption on a rotatable stage **20,** the stage **20** is rotated for rotating the flowable film **22,** a release solution **33** is supplied from a first nozzle 31 to the peripheral portion of the flowable film **22** and a release solution **34** is supplied from a second nozzle **32** to the back surface of the peripheral portion of the substrate **21.**

Thus, as shown in FIG. **8B,** the peripheral portion of the flowable film **22** can be removed as well as the material with flowability having been adhered onto the peripheral portion of the back surface of the substrate **21** can be removed.

Next, while continuously rotating the stage **20,** the supply of the release solutions **33** and **34** is stopped, so as to dry the flowable film **22.** In this manner, as shown in FIG. **8C,** the flowable film **22** whose peripheral portion has been selectively removed can be obtained.

It is noted that the first method is preferably performed before the transferring process for the flowable film **22.**

Since the peripheral portion of the flowable film **22** is removed while rotating the stage 20 together with the flowable film **22** in the first method, this method is suitable when the plane shape of the substrate **21** is in the shape of a circle or a polygon with a large number of vertexes.

Now, the second method for selectively removing the peripheral portion of a flowable film **22** will be described with reference to FIGS. **9A** through **9C.**

First, as shown in FIG. **9A,** after a substrate **21** on which the flowable film **22** is formed is held through vacuum adsorption on a rotatable stage **20,** the stage **20** is rotated for rotating the flowable film **22,** and the peripheral portion of the flowable film **22** is irradiated with light **36** emitted from a photoirradiation device **35,** so as to modify the peripheral portion by causing a photochemical reaction in the peripheral portion (irradiated portion) of the flowable film **22.** The light **36** used in this case is preferably UV or light of a shorter wavelength than UV.

Next, as shown in FIG. **9B,** after stopping the rotation of the stage **20** together with the flowable film **22,** a solution **37** such as a developer is supplied over the flowable film **22.** Thus, the peripheral portion of the flowable film **22** having been modified is dissolved in the solution **37,** and hence, the peripheral portion of the flowable film **22** can be selectively removed.

Then, as shown in FIG. **9C,** the stage **20** is rotated together with the flowable film **22** again, so as to remove the solution **37** remaining on the flowable film **22** to the outside by using centrifugal force. In this case, while or after removing the solution **37,** a rinsing solution is preferably supplied onto the flowable film **22** so as to remove the solution **37** still remaining. In this manner, the flowable film **22** whose peripheral portion has been selectively removed can be obtained.

It is noted that the second method is preferably performed before the transferring process for the flowable film **22.**

Since the peripheral portion of the flowable film **22** is selectively irradiated with the light 36 in the second method, this method is applicable not only when the plane shape of the substrate **21** is in the shape of a circle or a polygon with a large number of vertexes but also when it is in the shape of a polygon with a small number of vertexes such as a triangle or a rectangle.

### (EMBODIMENT 4)

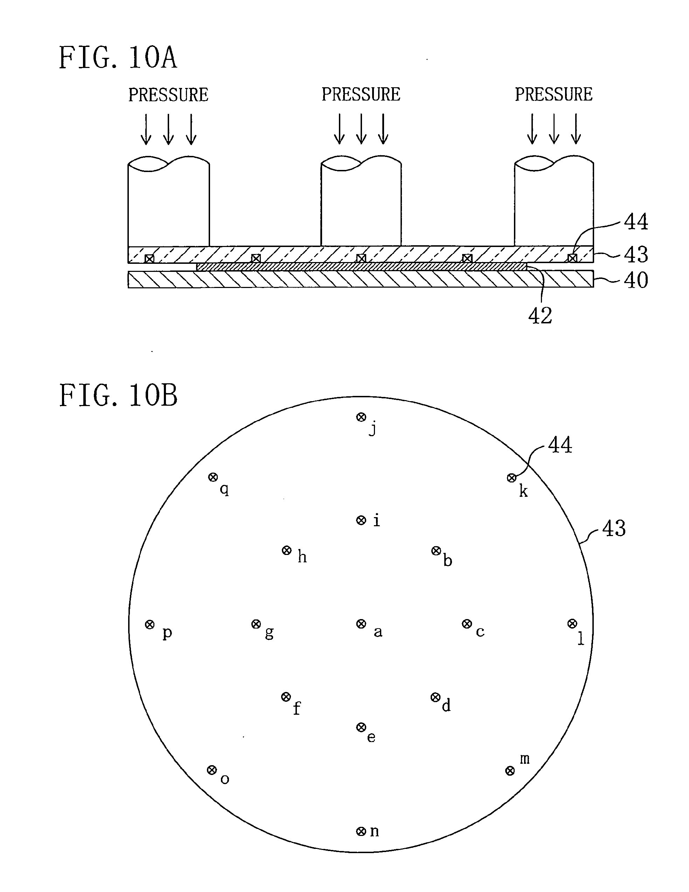

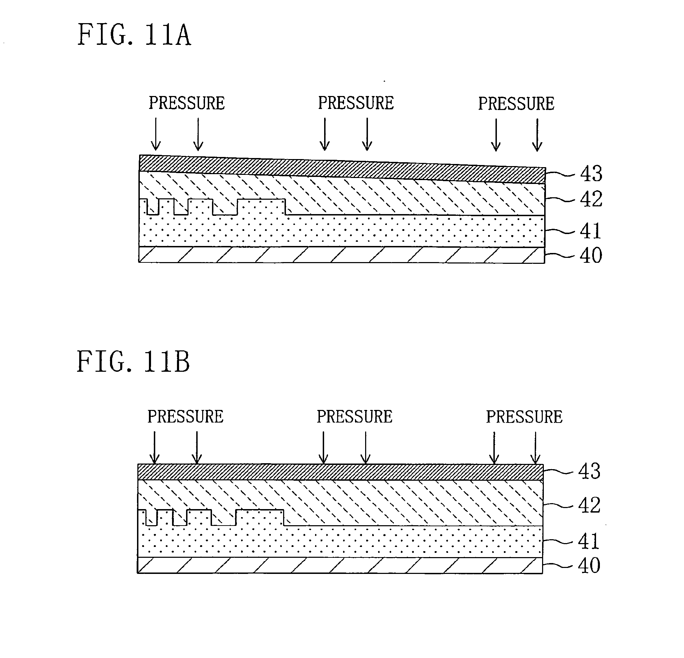

A method for forming a semiconductor device according to Embodiment 4 will now be described with reference to FIGS. **10A, 10B, 11A** and **11B.**

In Embodiment 4, a preferable method for planarizing the top face of the flowable film obtained in Embodiment 1 or 2 is described, and in this method, a plurality of distances between the surface of the substrate or the stage and the pressing face of the pressing member are measured and the flowable film is pressed in such a manner that these plural distances are equal to one another.

First, as shown in FIG. **10A**, after forming a flowable film **42** on a step layer (not shown in the drawing) above a substrate **40** by the method of Embodiment 1 or 2, a pressing member **43** having a plurality of distance sensors **44** on its flat pressing face is used for planarizing the top face of the flowable film **42.** In Embodiment 4, the outside dimension of the stage **20** (see FIG. **4C** or **5B)** is preferably larger than that of the substrate **40.**

In this case, a plurality of distances between the surface of the substrate **40** or the surface of the stage **20** (see FIG. **4C** or **5B)** on which the substrate **40** is placed and the pressing face of the pressing member **43** are measured with the plural distance sensors **44,** and the flowable film **42** is planarized by pressing the flowable film **42** with the pressing member **43** in such a manner that the plural distances are equal to one another. Specifically, information of the plural distances measured with the plural distance sensors **44** is fed back to pressing means for pressing the pressing member **43,** so that the flowable film **42** can be pressed in such a manner that the plural distances are equal to one another. The feedback control may be executed by using a computer. Also, in measuring the plural distances between the surface of the substrate **40** or the surface of the stage **20** (see FIG. **4C** or **5B)** on which the substrate **40** is placed and the pressing face of the pressing member **43,** each distance is preferably measured by measuring capacitance per unit area in the corresponding measurement position. Thus, the plural distances can be easily and definitely measured.

Now, the method for measuring the plural distances between the surface of the substrate **40** and the pressing face of the pressing member **43** will be described with reference to FIG. **10B.**

In FIG. **10B**, **a, b, c,** ... and **q** denote positions where the distance sensors **44** are respectively provided. The positions **a** through **q** are preferably optimized in accordance with the mechanism of the pressing member **43** so as to be set to positions where the distances between the surface of the substrate **40** or the surface of the stage where the substrate **40** is placed and the surface of the flowable film **42** can be efficiently measured. For example, the sensor positions **a** through **i** at the center are suitable to measure the distances between the surface of the substrate **40** and the surface of the flowable film **42,** and the sensor positions **j** through **q** in the peripheral portion are suitable to measure the distances between the surface of the stage where the substrate **40** is placed and the surface of the flowable film **42.**

Accordingly, merely the distances between the surface of the substrate **40** and the surface of the flowable film **42** may be measured with the distance sensors **44** provided in the sensor positions **a** through i alone, merely the distances between the surface of the stage where the substrate **40** is placed and the surface of the flowable film **42** may be measured with the distance sensors **44** provided in the sensor positions **j** through **q** alone, or the distances between the surface of the substrate **40** and the surface of the flowable film **42** and the distances between the surface of the stage where the substrate **40** is placed and the surface of the flowable film **42** may be measured with the distance sensors **44** provided in the sensor positions **a** through **q.**

Alternatively, in the case where the pressing face of the pressing member **44** can be finely adjusted, after the distances between the surface of the substrate **40** and the surface of the flowable film **42** are adjusted with the distance sensors **44** provided in the sensor positions a through **i,** the distances between the surface of the substrate **40** and the surface of the flowable film **42** may be adjusted with the distance sensors **44** provided in the sensor positions **j** through **q.** Thus, more highly accurate flatness can be realized. It is noted that the number and the positions of the distance sensors **44** may be optimized in accordance with a desired degree of flatness.

In Embodiment 1, it is significant but is not easy to equalize a distance of the surface of the flowable film **12A** from the surface of the substrate **10.** In other words, in Embodiment 1, the distance of the surface of the flowable film **12A** from the surface of the substrate 10 can be made uniform by previously setting the distance between the surface of the substrate **10** and the pressing face of the pressing member **13** to be uniform. However, in this method, it is necessary to set the distance between the surface of the substrate **10** and the pressing face of the pressing member **13** to be uniform every given period of time, namely, every time the pressing face of the pressing member **13** has pressed a given number of flowable films **12A.**

However, in Embodiment 4, the distance of the surface of the flowable film **42** from the surface of the substrate **40** can be always uniform, and hence, an operation for making the distance between the surface of the substrate **40** and the pressing face of the pressing member **43** uniform every given period of time can be omitted.

The process for adjusting the distance between the surface of the substrate **40** and the pressing face of the pressing member **43** to be uniform may be performed before, while or after pressing the flowable film **42** with the pressing member **43.**

FIG. **11A** shows a cross-section of the flowable film **42** obtained when the distance between the pressing face of the pressing member **43** and the surface of the substrate **40** provided below a step layer **41** is ununiform, and FIG. **11B** shows a cross-section of the flowable film **42** obtained when the distance between the pressing face of the pressing member **43** and the surface of the substrate **40** is kept uniform.

As is understood from comparison between FIGS. **11A** and **11B,** when the flowable film **42** is pressed with the distance between the pressing face of the pressing member **43** and the surface of the substrate **10** kept uniform, the top face of the flowable film **42** can be planarized with the distance of the flowable film **42** from the surface of the substrate **40** kept uniform.

### (EMBODIMENT 5)

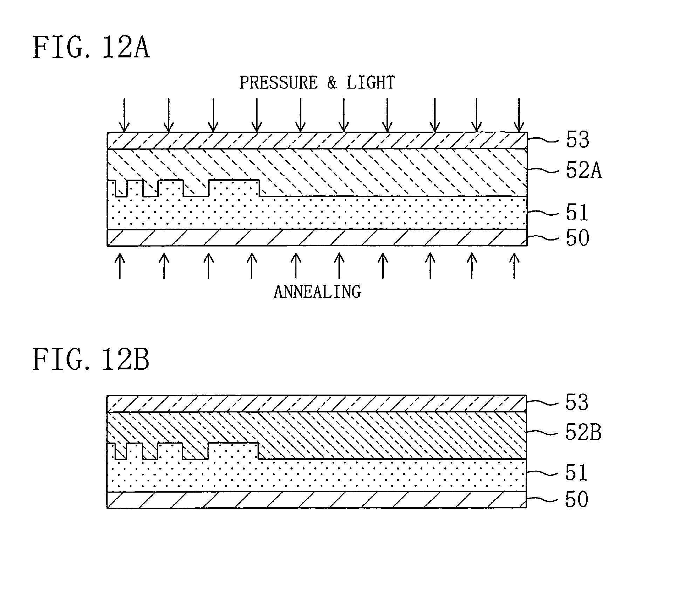

A method for forming a semiconductor device according to Embodiment 5 will now be described with reference to FIGS. **12A** and **12B.**

In the method of Embodiment 5, a flowable film **52A** is solidified by annealing the flowable film **52A** while irradiating it with light.

As shown in FIG. **12A,** while pressing a flat pressing face of a pressing member **53,** which is made of a light transmitting material such as quartz, against the flowable film **52A** formed on a step layer **51** above a substrate **50,** so as to planarize the top face of the flowable film **52A,** the flowable film **52A** is irradiated with light and annealed. The light used for the irradiation is, when the flowable film **52A** is solidified principally through a photochemical reaction, preferably UV or light of a shorter wavelength than UV, and when the flowable film **52A** is solidified principally through a thermal chemical reaction, preferably infrared light.

Thus, the flowable film **52A** is solidified through the photochemical reaction or the thermal chemical reaction, resulting in giving a solidified film **52B** as shown in FIG. **12B.**

The method for solidifying the flowable film **52A** principally through the photochemical reaction is suitable to a film of a photo-setting resin, such as a photosensitive resin film like a photoresist used in the lithography. Also, the method for solidifying the flowable film **52A** principally through the thermal chemical reaction is suitable to an organic film, an organic-inorganic film or an inorganic film made of a chemically amplified material composed of a material for generating an acid or a base through irradiation with light and a base polymer solidified by an acid or a base.

### (EMBODIMENT 6)

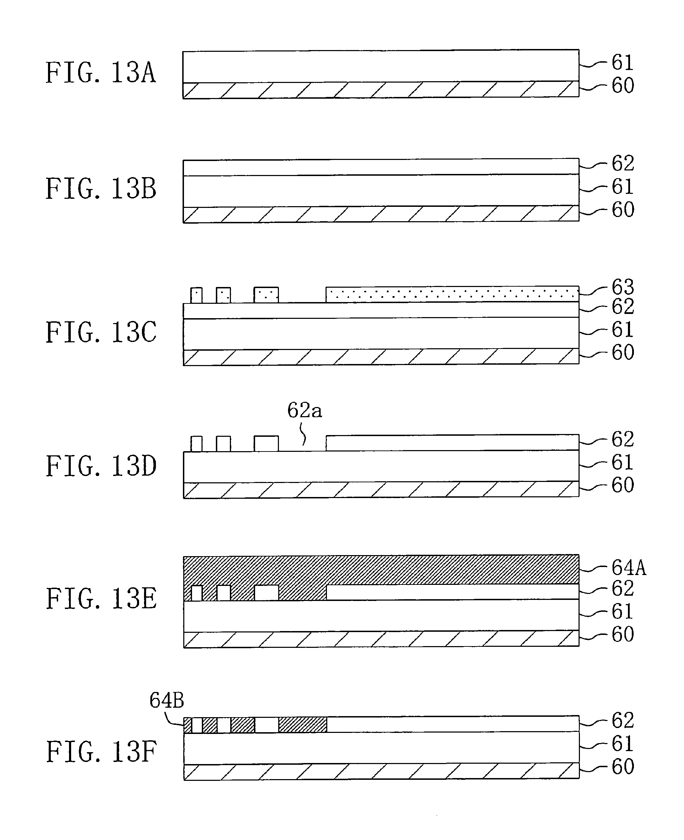

A method for forming a semiconductor device according to Embodiment 6 will now be described with reference to FIGS. **13A** through **13F, 14A** through **14D, 15A** through **15D** and **16A** through **16D.**

First, after forming an interlayer insulating film **61** on a substrate **60** as shown in FIG. **13A,** an organic film **62** of, for example, a photoresist film, an organic low-k film or the like is formed on the interlayer insulating film **61** by the spin coating method or the chemical vapor deposition (CVD) method as shown in FIG. **13B.** In this case, the organic film **62** preferably includes a material having an antireflection function corresponding to the wavelength of exposing light used in subsequently performed lithography. Thus, a process for forming an antireflection film below the organic film **62** can be omitted.

Instead of the organic film **62,** an inorganic film or an organic-inorganic film may be used. For example, an SOG film or the like formed by the spin coating method may be used. In particular, an SOG film that is not completely crosslinked but partly unreacted through baking at a temperature of approximately 200°C through approximately 300°C is used. Alternatively, an SOD (spin-on-dielectric) film recently frequently used as a low-k film material may be used.

Next, after forming a fist resist pattern **63** having an interconnect groove forming opening on the organic film **62** as shown in FIG. **13C,** the organic film **62** is dry etched by using the first resist pattern **63** as a mask, so as to form an interconnect groove **62a** in the organic film **62** as shown in FIG. **13D.** In this dry etching, an etching gas including, as a principal component, a mixed gas of an oxygen gas and a nitrogen gas or a mixed gas of a nitrogen gas and a hydrogen gas can be used.

Then, after forming a barrier metal layer (not shown in the drawing) on the organic film **62** including the inside of the interconnect groove **62a** by the sputtering method as shown in FIG **13E,** a first metal film **64A** of Cu, Ag, Au, Pt or the like is deposited on the barrier metal layer by, for example, the plating method.

Next, as shown in FIG. **13F,** an unnecessary portion of the first metal film **64A,** namely, a portion thereof exposed above the organic film **62,** is removed by the CMP, so as to form a buried interconnect **64B** made of the first metal film **64A.**

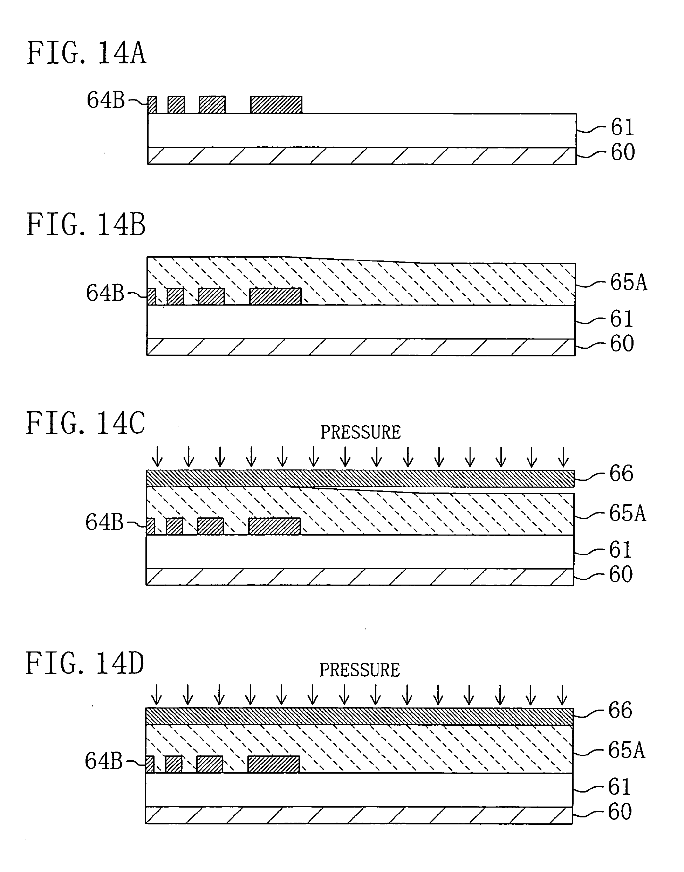

Then, as shown in FIG. **14A,** dry etching is performed for removing the organic film **62** and exposing the buried interconnect **64B.** Thereafter, a diffusion preventing film (not shown in the drawing) is formed on the buried interconnect **64B** by, for example, the CVD. It is noted that the dry etching of the organic film **62** may be anisotropic or isotropic. Also, as the diffusion preventing film, a single-layer film of a Si₃N₄ film, a SiC film or a SiCN film, or a multilayered film of such a film and a SiCO film can be used.

Next, as shown in FIG. **14B,** a flowable film **65A** is formed on the buried interconnect **64B** having the diffusion preventing film by supplying an insulating material with flowability in the form of a liquid or a gel by the spin coating method, the microscopic spraying method, the rotation roller method or the like in the same manner as in Embodiment 1. The thickness of the flowable film 65A can be appropriately set.

The flowable film **65A** may be any of the insulating films described in Embodiment 1, namely, an organic film, an inorganic film, an organic-inorganic film or a porous film. When such an insulating film is used, the resultant insulating film attains a lower dielectric constant than a general silicon oxide film, and thus, a film suitable to a semiconductor device refined to 100 nm or less can be realized. In particular, when a porous film is used as the flowable film **65A,** an insulating film with a very low dielectric constant of 2 or less can be realized.

Next, as shown in FIG. **14C,** after a flat pressing face of a pressing member **66** is brought into contact with the surface of the flowable film **65A,** a pressure is applied to the pressing member **66** so as to planarize the top face of the flowable film **65A** as shown in FIG. **14D.** In other words, the top face of the flowable film **65A** is made to be placed at the uniform height from the surface of the substrate **61.**

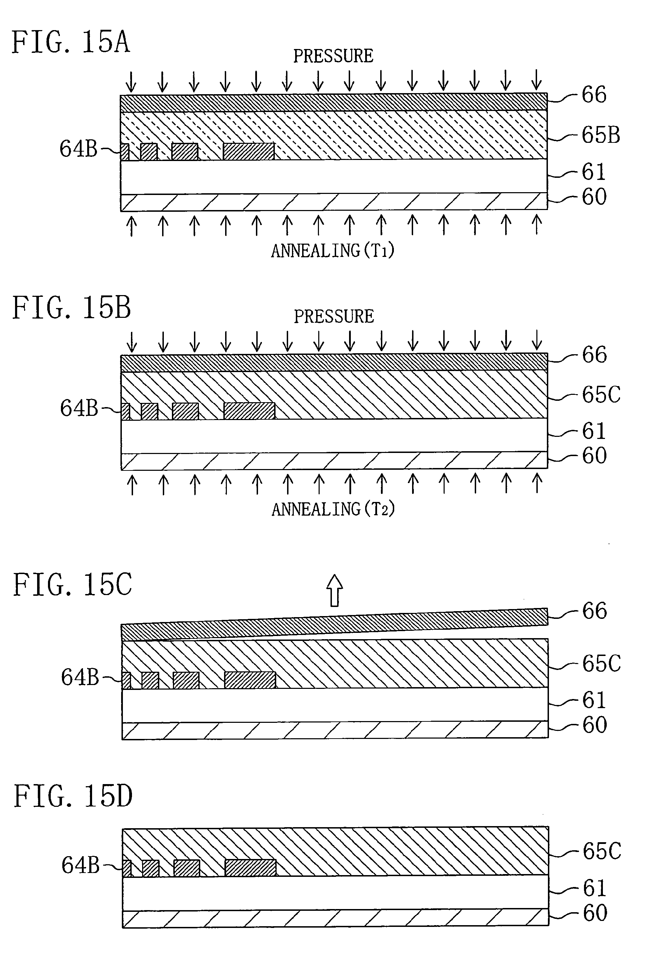

Then, as shown in FIG. **15A,** the substrate **60** together with the flowable film **65A** are annealed at a first temperature **(T1)** so as to cause a thermal chemical reaction in the insulating material. Thus, the flowable film **65A** is solidified to form a solidified film **65B** with a flat top face. In the solidifying process, any of the methods of Embodiments 1 through 4 suitable to the characteristics of the flowable film **65A** may be selected.

Next, as shown in FIG. **15B,** in the same manner as in Embodiments 1 and 2, the solidified film **65B** is annealed at a second temperature **(T2)** higher than the first temperature **(T1)** for burning the solidified film **65B,** so as to form a burnt film **65C** that is made of the solidified film **65B** burnt and has a flat top face. Thereafter, after the temperature of the burnt film **65C** is lowered to a temperature range from approximately 100°C to room temperature, as shown in FIG **15C,** the pressing member **66** is moved away from the burnt film **65C** and the temperature of the burnt film **65C** is lowered ultimately to room temperature. In this manner, as shown in FIG. **15D,** the burnt film **65C** having a flat top face is obtained. In the case where the burnt film **65C** is desired to be formed in a small thickness, the burnt film **65C** is subjected to the CMP or the etch back process.

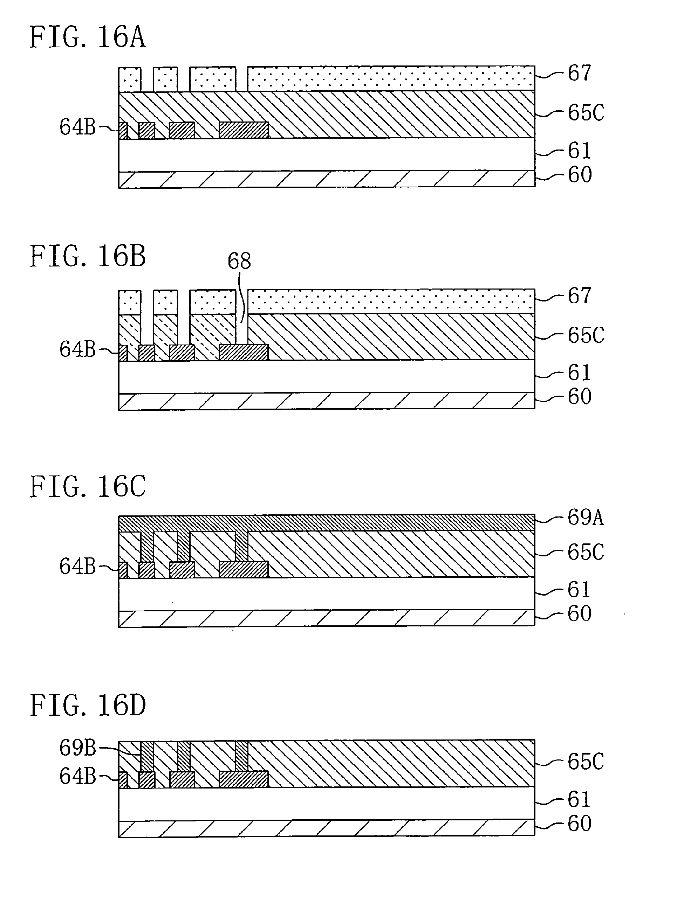

Then, as shown in FIG. **16A,** after forming a second resist pattern **67** having a via hole forming opening on the burnt film **65C,** the burnt film **65C** is dry etched by using the second resist pattern **67** as a mask, so as to form a via hole **68** in the burnt film **65C** as shown in FIG. **16B.** In this dry etching, an etching gas including fluorine, such as a CF₄ gas or a CHF₃ gas, can be used. Thereafter, the diffusion preventing film (not shown in the drawing) formed on the buried interconnect **64B** is dry etched, so as to expose the buried interconnect **64B.**

Next, as shown in FIG. **16C,** after depositing a barrier metal layer (not shown in the drawing) of Ta or TaN over the burnt film **65C** including the inside of the via hole **68** by the sputtering method or the CVD, a second metal film **69A** of, for example, copper is deposited over the barrier metal layer by, for example, the plating method. When the second metal film **69A** is deposited by the plating method, the second metal film **69A** is preferably grown by using, as a seed, a seed layer previously formed on the barrier metal layer by the sputtering. It is noted that the second metal film **69A** may be deposited by the CVD or the like instead of the plating method and that silver, gold, platinum or the like may be used instead of copper. These metals are preferred because they can be easily deposited by the plating method and have low resistance.

Then, an unnecessary portion of the second metal film **69A,** namely, a portion thereof exposed above the burnt film **62C,** is removed by the CMP. Thus, a buried plug 69B made of the second metal film **69A** is obtained.

Since the burnt film **65C** with no global level difference can be formed in Embodiment 6, local concentration of the film can be released in the insulating film, resulting in improving the reliability of the multilayered interconnects. Also, since the burnt film **65C** having a flat top face can be obtained, in the case where a mask pattern is formed on the burnt film **65C** by the lithography, degradation of a focal depth margin derived from a level difference can be suppressed. Therefore, as compared with conventional technique, a process margin (process window) can be increased, resulting in forming a highly accurate semiconductor device.

In the case where the solidified film **65B** largely outgassing is burnt in Embodiment 6, the burning process of Embodiment 2 is more effectively employed than that of Embodiment 1. In the case where the flowable film **65A** is made of a general film, the concentration of a solvent remaining in the flowable film **65A** can be controlled through the pre-bake, and hence, the film minimally outgases in the burning process. However, depending upon the composition of the flowable film **65A,** the film may largely outgas in some cases in the burning process where the film is annealed at a comparatively high temperature. In such a case, when the burning process of Embodiment 1 is employed, there arises a problem of uniformity or stability in the burnt film, and hence, the burning process of Embodiment 2 is preferably employed.

In particular, when the burnt film **65C** is a porous film, the effect of the burning process of Embodiment 2 is exhibited. In a porous film, most of the basic structure of the solidified film **65B** is formed in the annealing performed at the first temperature **(T1)** of the solidifying process, and a pore forming material added for forming pores is vaporized in the annealing performed at the second temperature (**T2**) of the following burning process. Therefore, the burning process of Embodiment 2 where the film is burnt with the pressing member 66 moved away from the solidified film **65B** is suitable. However, even in using a porous film, when a material in which the basic skeleton of the film is formed and a pore forming material is vaporized simultaneously in the solidifying process is used, a good burnt film **65C** can be obtained even by employing the burning process of Embodiment 1.

Since the burnt film **65C** is used as an insulating film of a semiconductor device in Embodiment 6, the annealing temperature of the solidifying process (the first temperature) is preferably approximately 150°C through 300°C, and the annealing temperature of the burning process (the second temperature) is preferably approximately 350°C through 450°C.

### (EMBODIMENT 7)

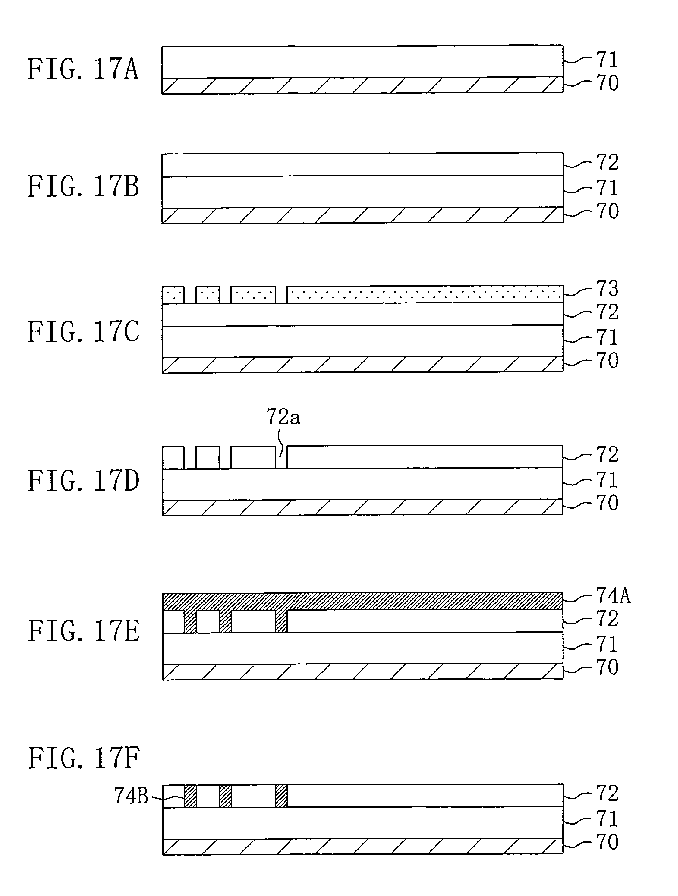

A method for forming a semiconductor device according to Embodiment 7 will now be described with reference to FIGS. **17A** through **17F, 18A** through **18D, 19A** through **19D** and **20A** through **20D.**

First, after forming an interlayer insulating film **71** on a substrate **70** as shown in FIG. **17A,** an organic film **72** of, for example, a photoresist film, an organic low-k film or the like is formed on the interlayer insulating film **71** by the spin coating method or the chemical vapor deposition (CVD) method as shown in FIG. **17B.**

Instead of the organic film **72,** an inorganic film or an organic-inorganic film may be used. For example, an SOG film or the like formed by the spin coating method may be used. In particular, an SOG film that is not completely crosslinked but partly unreacted through baking at a temperature of approximately 200°C through approximately 300°C is used. Alternatively, an SOD (spin-on-dielectric) film recently frequently used as a low-k film material may be used.

Next, after forming a fist resist pattern **73** having a via hole forming opening on the organic film **72** as shown in FIG. **17C,** the organic film **72** is dry etched by using the first resist pattern **73** as a mask, so as to form a via hole **72a** in the organic film **72** as shown in FIG. **17D.**

Then, after forming a barrier metal layer (not shown in the drawing) on the organic film **72** including the inside of the via hole 72a by the sputtering method as shown in FIG. **17E,** a first metal film **74A** of Cu, Ag, Au, Pt or the like is deposited on the barrier metal layer by, for example, the plating method.

Next, as shown in FIG. **17F,** an unnecessary portion of the first metal film **74A,** namely, a portion thereof exposed above the organic film **72,** is removed by the CMP, so as to form a buried plug **74B** made of the first metal film **74A.**

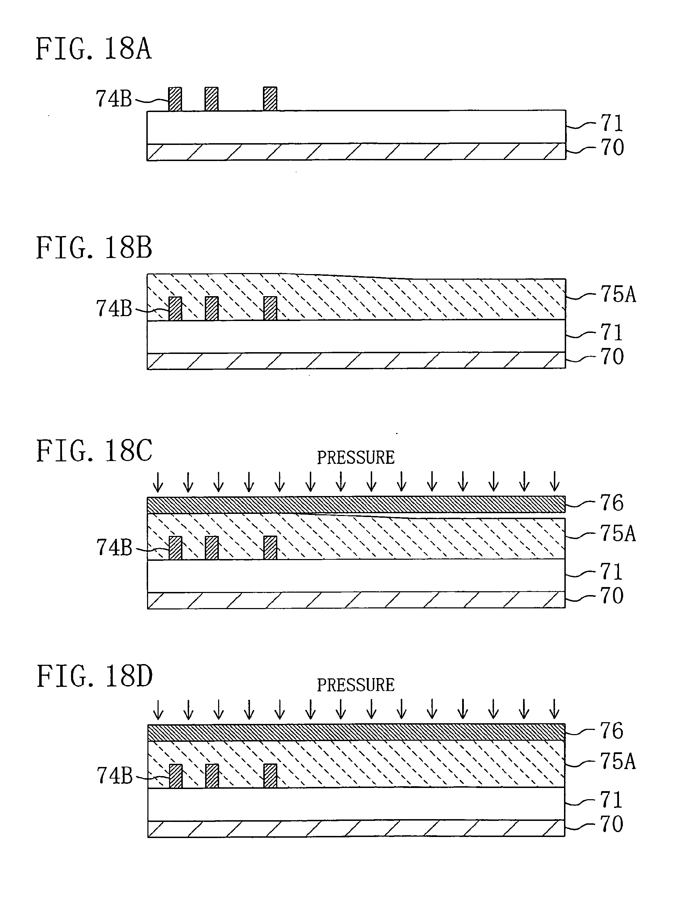

Then, as shown in FIG. **18A,** dry etching is performed for removing the organic film **72** and exposing the buried plug **74B.** Thereafter, a diffusion preventing film (not shown in the drawing) is formed on the buried plug **74B** by, for example, the CVD.

Next, as shown in FIG. **18B,** a flowable film **75A** is formed on the buried plug 74B having the diffusion preventing film by supplying an insulating material with flowability in the form of a liquid or a gel by the spin coating method, the microscopic spraying method, the rotation roller method or the like in the same manner as in Embodiment 1. The flowable film **75A** may be any of the insulating films described in Embodiment 1, namely, an organic film, an inorganic film, an organic-inorganic film or a porous film.

Next, as shown in FIG. **18C,** after a flat pressing face of a pressing member **76** is brought into contact with the surface of the flowable film **75A,** a pressure is applied to the pressing member **76** so as to planarize the top face of the flowable film **75A** as shown in FIG. **18D.**

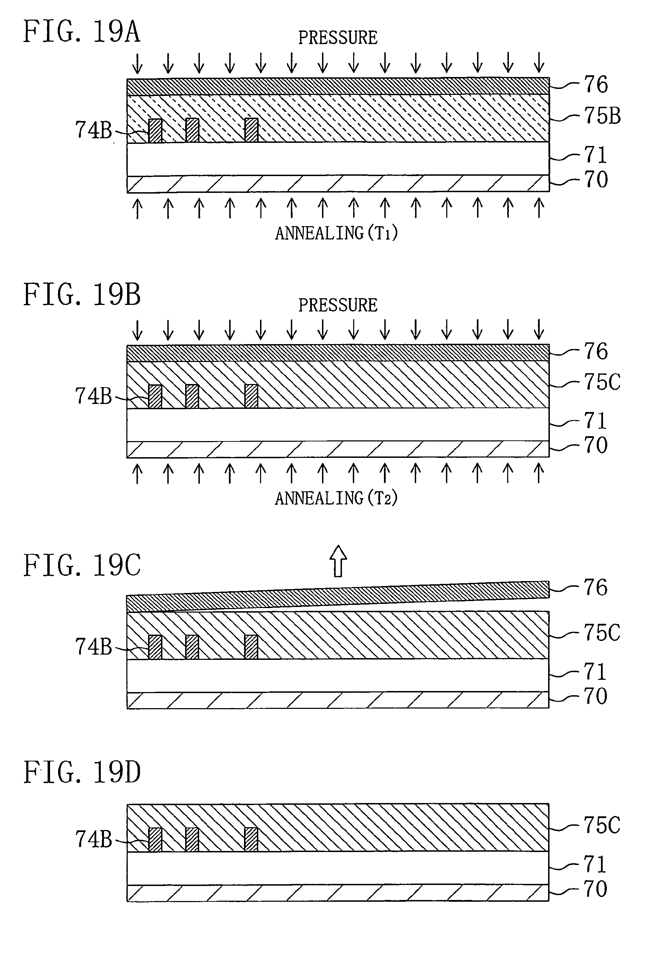

Then, as shown in FIG. **19A,** the substrate **70** together with the flowable film **75A** are annealed at a first temperature **(T1)** so as to cause a thermal chemical reaction in the insulating material. Thus, the flowable film **75A** is solidified to form a solidified film **75B** with a flat top face. In the solidifying process, any of the methods of Embodiments 1 through 4 suitable to the characteristics of the flowable film **75A** may be selected.

Next, as shown in FIG. **19B,** in the same manner as in Embodiments **1** and **2,** the solidified film **75B** is annealed at a second temperature (**T2**) higher than the first temperature **(T1)** for burning the solidified film **75B,** so as to form a burnt film **75C** that is made of the solidified film **75B** burnt and has a flat top face. Thereafter, after the temperature of the burnt film **75C** is lowered to a temperature range from approximately 100°C to room temperature, as shown in FIG. **19C,** the pressing member **76** is moved away from the burnt film **75C** and the temperature of the burnt film **75C** is lowered ultimately to room temperature. In this manner, as shown in FIG. **19D,** the burnt film **75C** having a flat top face is obtained.

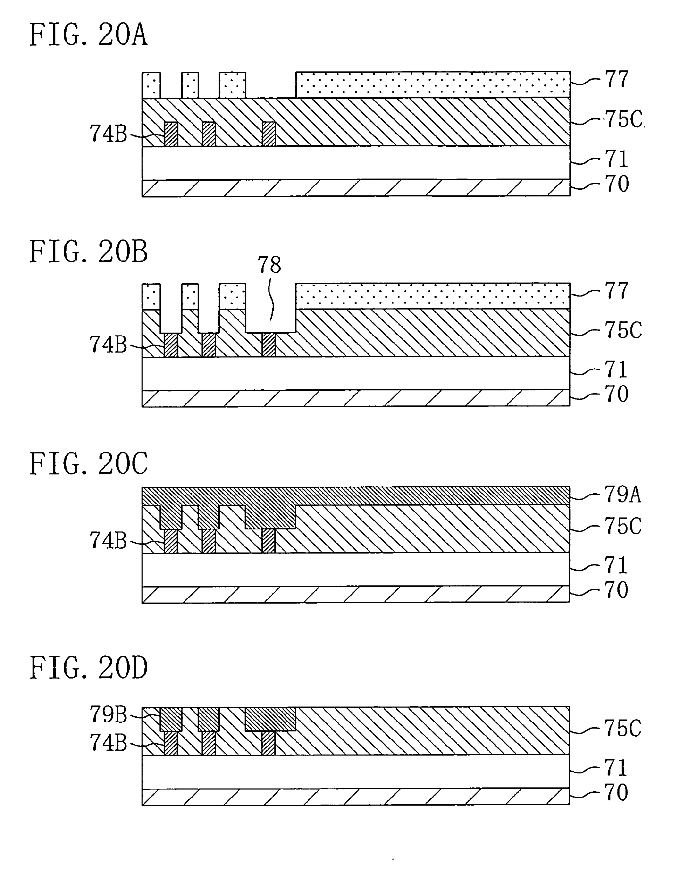

Then, as shown in FIG. **20A,** after forming a second resist pattern **77** having an interconnect groove forming opening on the burnt film **75C,** the burnt film **75C** is dry etched by using the second resist pattern **77** as a mask, so as to form an interconnect groove **78** in the burnt film **75C** as shown in FIG. **20B.** Thereafter, the diffusion preventing film (not shown in the drawing) formed on the buried plug **74B** is dry etched, so as to expose the buried plug **74B**.

Next, as shown in FIG. **20C,** after depositing a barrier metal layer (not shown in the drawing) of Ta or TaN over the burnt film **75C** including the inside of the interconnect groove **78** by the sputtering method or the CVD, a second metal film **79A** of, for example, copper is deposited over the barrier metal layer by, for example, the plating method.

Then, an unnecessary portion of the second metal film **79A,** namely, a portion thereof exposed above the burnt film **75C,** is removed by the CMP. Thus, a buried interconnect **79B** made of the second metal film **79A** is obtained.

Since the burnt film **75C** with no global level difference can be formed in Embodiment 7, local concentration of stress can be released in the insulating film, resulting in improving the reliability of the multilayered interconnects. Also, since the burnt film **75C** having a flat top face can be obtained, in the case where a mask pattern is formed on the burnt film **75C** by the lithography, degradation of a focal depth margin derived from a level difference can be suppressed. Therefore, as compared with conventional technique, a process margin (process window) can be increased, resulting in forming a highly accurate semiconductor device.

Since the burnt film **75C** is used as an insulating film of a semiconductor device in Embodiment 7, the annealing temperature of the solidifying process (the first temperature) is preferably approximately 150°C through 300°C, and the annealing temperature of the burning process (the second temperature) is preferably approximately 350°C through 450°C.

### Industrial Applicability

The present invention is useful as a method for forming a semiconductor device.

## Claims

1. A method for forming a semiconductor device comprising the steps of:
forming, on a substrate, a flowable film made of an insulating material with flowability;
planarizing a top face of said flowable film by pressing said flowable film with a flat pressing face of a pressing member;
forming a solidified film with a flat top face by solidifying said flowable film whose top face has been planarized through annealing of said flowable film performed at a first temperature with said pressing face pressed against said flowable film; and
forming a burnt film with a flat top face by burning said solidified film through annealing of said solidified film with a flat top face performed at a second temperature higher than said first temperature.

2. A method for forming a semiconductor device comprising the steps of:
forming, on a substrate, a flowable film made of an insulating material with flowability over said substrate including a buried interconnect formed and exposed on said substrate;
planarizing a top face of said flowable film by pressing said flowable film with a flat pressing face of a pressing member;
forming a solidified film with a flat top face by solidifying said flowable film whose top face has been planarized through annealing of said flowable film performed at a first temperature with said pressing face pressed against said flowable film;
forming a burnt film with a flat top face by burning said solidified film through annealing of said solidified film with a flat top face performed at a second temperature higher than said first temperature; and
forming a buried plug connected at least to said interconnect by forming a via hole in said burnt film and filling said via hole with a metal material.

3. A method for forming a semiconductor device comprising the steps of:
forming, on a substrate, a flowable film made of an insulating material with flowability over a substrate including a buried plug formed and exposed on said substrate;
planarizing a top face of said flowable film by pressing said flowable film with a flat pressing face of a pressing member;
forming a solidified film with a flat top face by solidifying said flowable film whose top face has been planarized through annealing of said flowable film at a first temperature with said pressing face pressed against said flowable film;
forming a burnt film with a flat top face by burning said solidified film through annealing of said solidified film with a flat top face at a second temperature higher than said first temperature; and
forming a buried interconnect connected at least to said plug by forming an interconnect groove in said burnt film and filling said interconnect groove with a metal material.

4. The method for forming a semiconductor device of any of Claims 1 through 3,
wherein said first temperature is approximately 150°C through approximately 300°C.

5. The method for forming a semiconductor device of any of Claims 1 through 4,
wherein said second temperature is approximately 350°C through approximately 450°C.

6. The method for forming a semiconductor device of any of Claims 1 through 3,
wherein said insulating material with flowability is in the form of a liquid or a gel.

7. The method for forming a semiconductor device of any of Claims 1 through 3,
wherein in the step of forming a flowable film, said flowable film is formed on said substrate by supplying said insulating material with flowability onto said substrate rotated.

8. The method for forming a semiconductor device of any of Claims 1 through 3,
wherein in the step of forming a flowable film, said flowable film is formed on said substrate by supplying said insulating material with flowability onto said substrate and rotating said substrate after the supply.

9. The method for forming a semiconductor device of any of Claims 1 through 3,
wherein in the step of forming a flowable film, said flowable film is formed on said substrate by supplying, in the form of a shower or a spray, said insulating material with flowability onto said substrate rotated.

10. The method for forming a semiconductor device of any of Claims 1 through 3,
wherein in the step of forming a flowable film, said flowable film is formed on said substrate by supplying said insulating material with flowability from a fine spray vent of a nozzle onto said substrate with said nozzle having said fine spray vent and said substrate relatively moved along plane directions.

11. The method for forming a semiconductor device of any of Claims 1 through 3,
wherein in the step of forming a flowable film, said flowable film is formed on said substrate by supplying said insulating material with flowability having been adhered to a surface of a roller onto said substrate with said roller rotated.

12. The method for forming a semiconductor device of any of Claims 1 through 3, further comprising, between the step of forming a flowable film and the step of planarizing a top face of said flowable film, a step of selectively removing a peripheral portion of said flowable film.

13. The method for forming a semiconductor device of Claim 12,
wherein the step of selectively removing a peripheral portion of said flowable film is performed by supplying a solution for dissolving said insulating material with flowability onto said peripheral portion of said flowable film with said flowable film rotated.

14. The method for forming a semiconductor device of Claim 12,
wherein the step of selectively removing a peripheral portion of said flowable film is performed by modifying said peripheral portion of said flowable film through irradiation with light and removing said modified peripheral portion.

15. The method for forming a semiconductor device of any of Claims 1 through 3,
wherein in the step of planarizing a top face of said flowable film, a plurality of distances between a surface of said substrate and said pressing face are measured, and said flowable film is pressed with said pressing face in such a manner that said plurality of distances are equal to one another.

16. The method for forming a semiconductor device of any of Claims 1 through 3,
wherein in the step of planarizing a top face of said flowable film, a plurality of distances between a surface of a stage where said substrate is placed and said pressing face are measured, and said flowable film is pressed with said pressing face in such a manner that said plurality of distances are equal to one another.

17. The method for forming a semiconductor device of Claim 15 or 16,
wherein said plurality of distances are measured by measuring capacitance per unit area in respective measurement positions.

18. The method for forming a semiconductor device of any of Claims 1 through 3,
wherein said pressing face of said pressing member has a hydrophobic property.

19. The method for forming a semiconductor device of any of Claims 1 through 3,
wherein said insulating material with flowability is a photo-setting resin, and
the step of forming a solidified film includes a sub-step of irradiating said flowable film with light.

20. The method for forming a semiconductor device of any of Claims 1 through 3,
wherein said insulating material with flowability is an organic material, an inorganic material, an organic-inorganic material, a photo-setting resin or a photosensitive resin.

21. The method for forming a semiconductor device of any of Claims 1 through 3,
wherein in the step of forming a burnt film, said solidified film is annealed at said second temperature with said pressing face pressed against said solidified film.

22. The method for forming a semiconductor device of any of Claims 1 through 3,
wherein in the step of forming a burnt film, said solidified film is annealed at said second temperature with said pressing face moved away from said solidified film.

23. The method for forming a semiconductor device of any of Claims 1 through 3,
wherein said burnt film is a porous film.

24. The method for forming a semiconductor device of any of Claims 1 through 3,
wherein said burnt film has a dielectric constant of approximately 4 or less.

25. The method for forming a semiconductor device of Claim 2, further comprising, before the step of forming a flowable film, a step of forming said buried interconnect exposed on said substrate by forming a buried interconnect in an organic film formed on said substrate and removing said organic film.

26. The method for forming a semiconductor device of Claim 3, further comprising, before the step of forming a flowable film, a step of forming said buried plug exposed on said substrate by forming a buried plug in an organic film formed on said substrate and removing said organic film.

27. The method for forming a semiconductor device of Claim 25 or 26,
wherein said organic film is removed by wet etching in the step of forming said buried interconnect or said buried plug.

28. The method for forming a semiconductor device of Claim 25 or 26,
wherein said organic film is removed by dry etching in the step of forming said buried interconnect or said buried plug.
